(19) Europäisches Patentamt
European Patent Office
Office européen des brevets

(11) **EP 4 506 705 A1**

(12) **EUROPEAN PATENT APPLICATION**
published in accordance with Art. 153(4) EPC

(43) Date of publication:
**12.02.2025 Bulletin 2025/07**

(21) Application number: **24781152.4**

(22) Date of filing: **25.03.2024**

(51) International Patent Classification (IPC):
**G01R 31/40** *(2020.01)*   **G01R 19/175** *(2006.01)*
**G01R 23/00** *(2006.01)*   **G01R 23/20** *(2006.01)*
**G01R 21/00** *(2006.01)*

(52) Cooperative Patent Classification (CPC):
**G01R 19/175; G01R 21/00; G01R 23/00;**
**G01R 23/20; G01R 31/40**

(86) International application number:
**PCT/KR2024/003687**

(87) International publication number:
**WO 2024/205161 (03.10.2024 Gazette 2024/40)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **27.03.2023 KR 20230039835**

(71) Applicant: **Hanwha Solutions Corporation**
**Jung-gu**
**Seoul 04541 (KR)**

(72) Inventors:
• **PARK, Min Gi**
  **Seoul 04541 (KR)**
• **LEE, Joon Min**
  **Seoul 04541 (KR)**
• **PARK, Sung Youl**
  **Seoul 04541 (KR)**
• **KO, Tae Hoon**
  **Seoul 04541 (KR)**

(74) Representative: **Mooser, Sebastian Thomas**
**Wuesthoff & Wuesthoff**
**Patentanwälte und Rechtsanwalt PartG mbB**
**Schweigerstraße 2**
**81541 München (DE)**

(54) **METHOD FOR DETECTING WHETHER THERE IS ISLANDING AND POWER CONDITIONING SYSTEM USING SAME**

(57)   A power conditioning system according to an aspect includes a processor that is configured to identify a first grid frequency variation and a measured frequency according to injection of reactive power, identify whether at least one of the first grid frequency variation or the measured frequency exceeds a critical range, and detect an islanding based on the number of times of exceeding the critical range within a predefined period of time.

FIG. 1

## Description

## Technical field

The present disclosure relates to a method of detecting islanding and a power conditioning system using the same.

## Background

A distributed power system (hereinafter, 'grid-connected system') such as a grid connected inverter, etc. has to secure stability by determining a grid situation in real-time. An inverter has to detect that there is an abnormality in a grid within short period of time and to perform a protective operation for blocking an alternating current (AC) output.

One of abnormalities that may occur in a grid-connected system is islanding. Islanding denotes that a distributed power generator continuously supplies power to one location even when there is no longer external grid power. When the islanding may not be detected and an AC output is continuously maintained, failures or accidents may occur in a grid and load. Also, when an operator is in contact with an inverter via grid connection equipment, there may be a damage to the body of the operator. Therefore, a function of detecting an islanding situation in a grid-connected system (anti-islanding function) has been required.

Also, there is a need to improve reliability in an anti-islanding function.

## Disclosure

## Technical Problem

Provided are a method of detecting islanding and a power conditioning system using the same. Provided is a computer-readable recording medium having recorded thereon a program, which, when executed by a computer, performs the above method. The technical goal of the disclosure is not limited thereto, and other technical goals may exist.

## Technical Solution

A power conditioning system according to an aspect includes a processor that is configured to identify a first grid frequency variation and a measured frequency according to injection of reactive power, identify whether at least one of the first grid frequency variation or the measured frequency exceeds a critical range, and detect an islanding based on the number of times of exceeding the critical range within a predefined period of time.

According to another aspect, a method of detecting an islanding includes identifying a first grid frequency variation and a measured frequency according to injection of reactive power, identifying whether at least one of the first grid frequency variation or the measured frequency exceeds a critical range, and detecting an islanding based on the number of times of exceeding the critical range within a predefined period of time.

According to another aspect, a computer-readable recording medium having recorded thereon a program, which when executed by a computer, performs the above method.

## Advantageous Effects

A function of detecting an islanding with high reliability may be implemented by utilizing occurrence of a low-order harmonic variation, as well as a frequency variation, as an active control element.

By flexibly changing conditions of an islanding detecting function according to the occurrence of low-order harmonics, the islanding may be normally detected without any functional defect even in a situation in which it is difficult to detect the islanding only with the frequency fluctuation.

During normal grid-connected operation, a possibility of false detection of the islanding may be lowered, and during actual occurrence of the islanding, the islanding may be organically detected with only a fine change in a grid status.

## Description of Drawings

FIG. 1 is a schematic diagram of a grid-connected system according to an embodiment.
FIG. 2 is a diagram showing an example in which a power conditioning system according to an embodiment operates.
FIG. 3 is a flowchart illustrating an example in which a power conditioning system according to an embodiment operates.
FIG. 4 is a diagram showing an example of a technique of identifying a low-order harmonic variation according to an embodiment.
FIG. 5 is a flowchart illustrating an example of processes for injecting reactive power according to an embodiment.
FIG. 6 is a flowchart showing an example of processes of identifying a reactive power injection amount according to an embodiment.
FIG. 7 is a flowchart illustrating another example of processes of injecting reactive power in a grid-connected system according to an embodiment.
FIG. 8 is a flowchart illustrating another example of processes of injecting reactive power in a grid-connected system according to an embodiment.
FIG. 9 is a flowchart illustrating an example of an islanding detection criterion variation technique according to occurrence of a low-order harmonic variation according to an embodiment.

FIG. 10 is a flowchart illustrating an example of an islanding detection technique according to an embodiment.

## Best Mode

A power conditioning system according to an aspect includes a processor that is configured to identify a first grid frequency variation and a measured frequency according to injection of reactive power, identify whether at least one of the first grid frequency variation or the measured frequency exceeds a critical range, and detect an islanding based on the number of times of exceeding the critical range within a predefined period of time.

## Mode for Invention

With respect to the terms used in embodiments of the disclosure, general terms currently and widely used are selected in view of function with respect to the disclosure. However, the terms may vary according to an intention of a technician practicing in the pertinent art, an advent of new technology, etc. In specific cases, terms may be chosen arbitrarily, and in this case, definitions thereof will be described in the description of the corresponding disclosure. Accordingly, the terms used in the description should not necessarily be construed as simple names of the terms, but be defined based on meanings of the terms and overall contents of the present disclosure.

It will be further understood that the terms "comprises" and/or "comprising," when used in this specification, specify the presence of stated components, but do not preclude the presence or addition of one or more components.

In description of the disclosure, the terms "first" and "second" may be used to describe various components, but the components are not limited by the terms. The terms may be used to distinguish one component from another component.

Hereinafter, one or more embodiments of the present disclosure will be described below with reference to accompanying drawings. The detailed descriptions provided below together with appended drawings are intended only to explain illustrative embodiments of the present disclosure, which should not be regarded as the sole embodiments of the present disclosure. In drawings, components irrelevant with the description may be omitted for clear description, and like reference numerals are used for similar components throughout the entire specification.

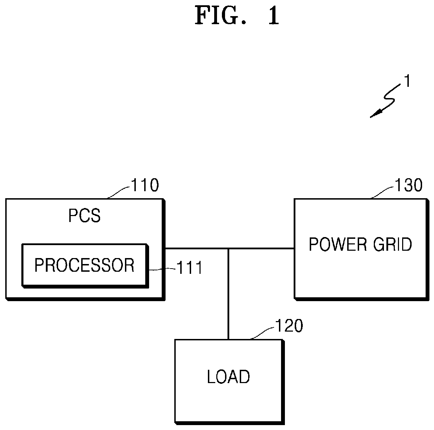

FIG. 1 is a schematic diagram of a grid-connected system according to an embodiment.

Referring to FIG. 1, a grid-connected system 1 includes a power conditioning system (hereinafter, referred to as PCS) 110, a load 120, and a power grid 130. In addition, universal components in addition to the components shown in FIG. 1 may be included in the grid-connected system 1.

The PCS 110 is a device for controlling overall operations of the components in the grid-connected system 1 for power management. For example, the PCS 1 may include an inverter, a power cutoff unit, etc.

A processor 111 included in the PCS 110 may detect whether the PCS 110 is disconnected from the power grid 130 and perform islanding.

The processor 111 may process instructions of a computer program by performing basic arithmetic operations, logic operations, and I/O operations. Here, the instructions may be provided from a memory in the PCS 110 or an external device. Additionally, the processor 111 may control overall operations of other components included in the PCS 110.

For example, the processor 111 may be implemented as an array of a plurality of logic gates, or as a combination of a universal microprocessor and a memory storing programs that may be executed in the microprocessor. For example, processor 111 may include a general-purpose processor, a central processing unit (CPU), a graphics processing unit (GPU), a neural network processing unit (NPU), a microprocessor, a digital signal processor (DSP), a controller, a microcontroller, a state machine, etc. Under some circumstances, the processor 111 may include an application-specific integrated circuit (ASIC), a programmable logic device (PLD), a field-programmable gate array (FPGA), etc. For example, the processor 160 may refer to a combination of processing devices, e.g., a combination of a DSP and a microprocessor, a combination of a plurality of microprocessors, a combination of one or more microprocessors in conjunction with a DSP core, or a combination of any other such configurations. For example, the processor 111 may include a microcontroller unit (MCU) for power control.

In addition, in FIG. 1, the processor 111 is included in the PCS 110, but is not limited thereto. In other words, the processor 111 may be included in a device other than the PCS 110 and may detect whether the PCS 110 is disconnected from the power grid 130 and performs the islanding.

Although not shown in FIG. 1, the grid-connected system 1 may include a renewable energy source that produces electricity using renewable energy such as solar heat, solar energy, biomass, wind power, small hydro, geothermal heat, marine energy, waste energy, etc. Here, the kind of renewable energy is not limited to any one kind. Also, the grid-connected system 1 may be applied to a distributed energy source.

Also, the grid-connected system 1 may further include a battery that stores power produced by the renewable energy source, power supplied from the power grid 130, etc., and supplies the power as necessary. For example, a battery may include at least one module and a plurality of battery cells included in each module.

The PCS 110 according to an embodiment may vary a criterion for detecting an islanding according to occurrence of low-order harmonic variation. Also, the PCS 110 may inject reactive power according to the low-order harmonic variation and/or grid frequency variation. That is, the PCS 110 may execute the islanding detection method with relatively high reliability by reflecting various factors for detecting the islanding.

Hereinafter, the operations of the PCS 110 and the grid-connected system 1 according to an embodiment are described in detail with reference to the drawings.

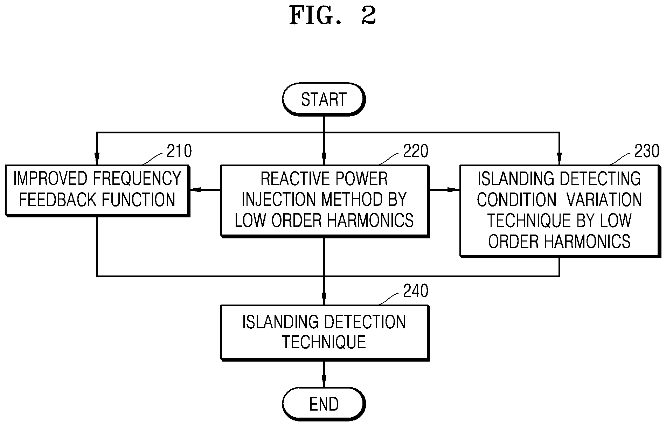

FIG. 2 is a diagram showing an example in which a power conditioning system according to an embodiment operates.

The islanding detection method executed in the grid-connected system 1 or the PCS 110 may include an improved frequency feedback function (hereinafter, referred to as IFF) 210, a reactive power injection method by low-order harmonics (hereinafter, referred to as RPILH) 220, an islanding detection condition variation technique by low-order harmonics 230, and an islanding detection technique 240. The techniques 210, 220, 230, and 240 may be implemented independently or may operate in combination with one another.

According to the IFF 210, when the grid frequency variation is minor, an injection amount of reactive power has an extremely small value. Therefore, according to the IFF 210, active responses that are sufficient to satisfy the islanding detecting condition may not be possible. Therefore, according to the RPILH 220, the islanding detection performance may be improved when the grid frequency variation is identified after injecting reactive power or the low-order harmonic variation is considered when determining the injection amount of reactive power according to the grid frequency variation.

The IFF 210 and the RPILH 220 are active response techniques and improve quick responsivity and accuracy of detecting the islanding by gradually causing a change in the grid frequency. In addition, the islanding detection condition variable technique by the low-order harmonic variation (230) is also an active technique for improving adaptability so as to recognize the current grid situation and deal with the situation flexibly. For example, the techniques 210, 220, and 230 may be complementary to one another. Additionally, the techniques 210, 220, and 230 may be performed in combination with one another or may be partially performed according to a designer's intention.

Hereinafter, an example in which the techniques 210, 220, and 230 are performed in combination with one another is described with reference to the drawings.

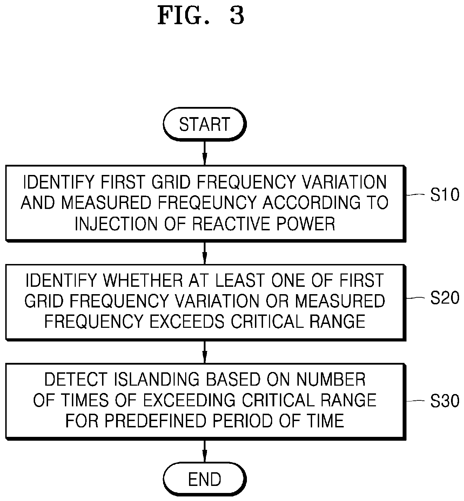

FIG. 3 is a flowchart illustrating an example in which a PCS according to an embodiment operates.

In operation S10, the processor 111 identifies a first grid frequency variation and a measured frequency according to the reactive power injection.

For example, when a situation in which the islanding is suspected to occur is sensed, the processor 111 may detect the islanding in consideration of 'grid frequency variation' and 'measured frequency'.

However, when the grid frequency variation is insufficient, it may be difficult to detect whether the frequency temporarily changes due to external factors in a normal grid-connected operating situation or the frequency changes due to the islanding.

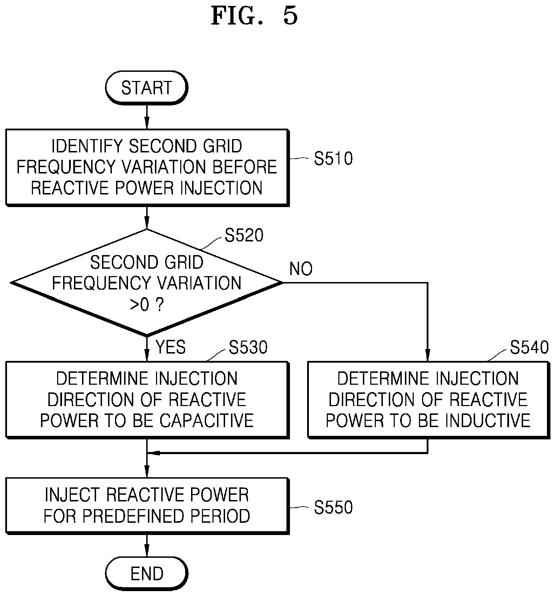

The processor 111 according to an embodiment may inject reactive power to facilitate observation of the grid frequency variation and the measured frequency. For example, the processor 111 may inject reactive power according to the IFF 210 or inject reactive power according to the RPILH 220. Also, the processor 111 may inject reactive power by considering both the IFF 210 and the RPILH 220. Examples in which the processor 111 injects reactive power are described later with reference to FIGS. 5 to 8.

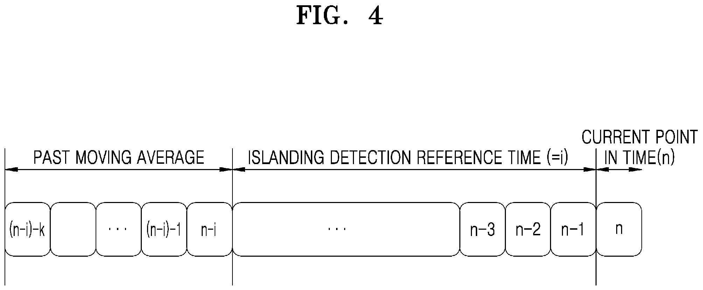

The processor 111 may identify the grid frequency variation through a difference between a grid frequency at a current point in time and a grid frequency variation at a previous point in time that is earlier to the current point in time as much as the islanding detecting time. An example in which the processor 1110 identifies the grid frequency variation is described with reference to FIG. 4.

In operation S20, the processor 111 identifies whether at least one of the first grid frequency variation or the measured frequency exceeds a critical range.

The processor 111 may identify whether the first grid frequency variation exceeds a first critical range and/or the measured frequency exceeds a second critical range.

For example, the processor 111 may detect the islanding with a detecting criterion with respect to the first grid frequency variation and the measured frequency. Here, the criterion for detecting the islanding may include the first critical range of the first grid frequency variation and the first critical number of times of exceeding the first critical range. Also, the criterion for detecting the islanding may include the second critical range of the measured frequency and the second number of times of exceeding the second critical range.

For example, the first critical range, the second critical range, the first critical number of times, and the second critical number of times may be adjusted according to the low-order harmonic variation. In other words, the first critical range, the second critical range, the first critical number of times, and the second critical number of times may vary depending on the low-order harmonic variation.

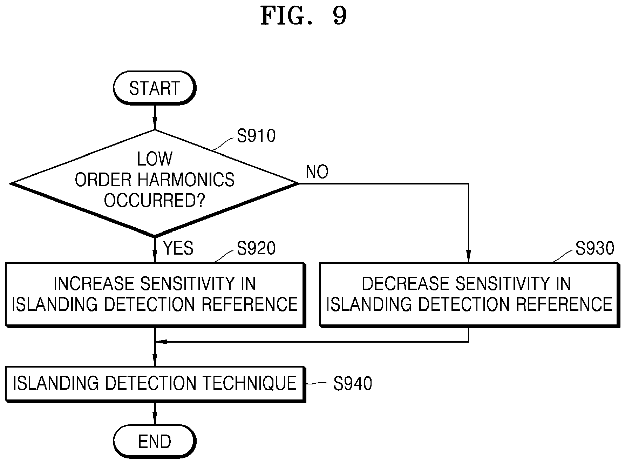

The processor 111 may identify the low-order harmonic variation through a difference between first low-order harmonics at a current point in time and second low-order harmonics at a previous point in time that is earlier to the current point in time as much as the islanding detection time. An example in which the processor 111 identifies the low-order harmonic variation is described later with reference to FIG. 4. Also, an example in which the processor 111 adjusts the critical range and the critical number of times according to the low-order harmonic variation is described later with reference to FIG. 9.

For example, when a situation in which the islanding is suspected to occur is sensed, the processor 111 identifies the number of times that the grid frequency variation exceeds the first critical range for a certain period of time after injecting the reactive power. For example, the first critical range may be a range greater than a predefined critical value.

When the number of times that the grid frequency variation exceeds the first critical range exceeds the first critical number of times, the processor 111 identifies whether an absolute magnitude of a frequency that is measured in real-time exceeds the second critical range.

For example, the second critical range may be divided based on over-frequency and low frequency. A range in which an absolute value of the measured frequency exceeds a certain reference value based on the over-frequency or in which an absolute value of the measured frequency is less than a certain reference value based on the low frequency may be defined as the second critical range. Here, the processor 111 identifies whether the number of times that the measured frequency exceeds the second critical range exceeds the second critical number of times.

In operation S30, the processor 111 detects the islanding based on the number of times of exceeding the critical range within a predefined period of time.

For example, when the number of times that the grid frequency variation exceeds the first critical range exceeds the first critical number of times and/or when the number of times that the measured frequency exceeds the second critical range exceeds the second critical number of times, the processor 111 may determine that the islanding is performed. Then, the processor 111 may perform follow-up actions. Here, the processor 111 may flexibly change the first critical range, the first critical number of times, the second critical range, and the second critical number of times according to the low-order harmonic variation.

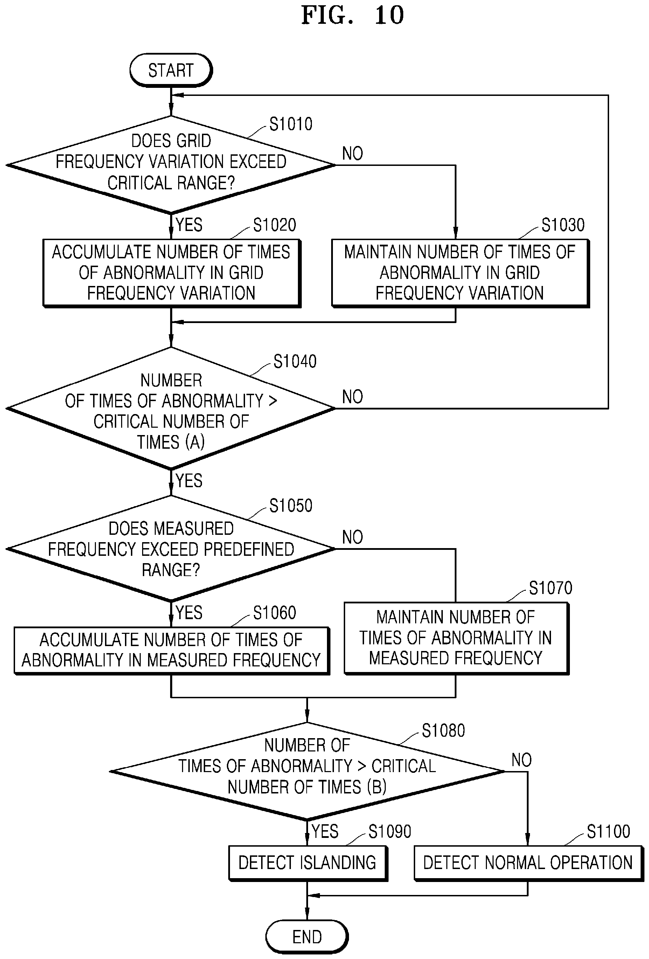

An example in which the processor 111 detects the islanding is described later with reference to FIG. 10.

According to the above description, the processor 111 may sense the occurrence of the low-order harmonic variation, as well as the frequency variation. In addition, the processor 111 may utilize the sensed elements as active control elements. Accordingly, a highly reliable islanding detection function may be implemented.

Also, the processor 111 may flexibly change conditions for detecting the islanding according to the occurrence of the low-order harmonics. Accordingly, even in the situation in which it is difficult to detect the islanding only with the change in the frequency, the processor 111 may normally detect the islanding.

Also, due to the operation of the processor 111, a possibility of false detection is reduced during normal grid-connected operation, and when an actual islanding operation occurs, the islanding may be organically detected with only minor changes in the grid status.

FIG. 4 is a diagram showing an example of a method of identifying the low-order harmonic variation according to an embodiment.

Referring to FIG. 4, processes in which the processor 111 identifies the grid frequency variation and the low-order harmonic variation are described in detail.

First, when the islanding occurs, a change in the grid frequency detection value of an inverter product is detected, to thereby detect the islanding. For example, the processor 111 may derive the grid frequency variation based on a difference between a past moving average and a current value as expressed in Equation 1 below. Here, a temporal interval between the past moving average and the current value may be set to be longer than a mandatory time for detecting the islanding in each country. For example, the past moving average may be calculated as an average value for one period (e.g., fifteenth period), but is not limited thereto.

【Equation 1】

$$F_{diff} = F_n - \left( \left( \sum_{m=0}^{l} F_{(n-i)-m} \right) / (l+1) \right)$$

(Fdiff: frequency moving average variation, Fn: grid frequency at the current point in time (n), i: islanding detection reference time)

Next, to analyze the low-order harmonics changing rapidly when the grid is shut off, the processor 111 may perform discrete Fourier transformation (hereinafter, DFT). The processor 111 may derive a root mean square (RMS) of second to fifth harmonics from among the low-order harmonic components through the DFT. Also, the processor 111 may identify the low-order harmonic variation through the variation in the low-order harmonics from the current point in time (n) based on the grid to the previous point in time (n-i) earlier to the current point as much as the islanding detection reference time (i).

As described above, the low-order harmonic variation may be calculated by using the RMS of the low-order harmonic component. Here, the temporal reference about the period of deriving the RMS may be a zero-crossing point in time of the grid voltage. However, the zero-crossing point in time may be a unidirectional cross point at which the grid voltage is switched from a negative value to a positive value.

In general, in the case of home inverter products, a switching frequency of an inverter is in tens of kHz, and thus, the number of samplings for collecting grid information (based on 50/60 Hz) is in unit of only a few hundreds. Therefore, in order to collect reliable information, the information may be collected from other areas than the zero-crossing point of the grid power.

For example, the RMS of the low-order harmonics at the current point in time (n) is derived as a value during k-periods based on the grid, and the RMS of the low-order harmonics at the past point in time (n-i) may be derived as a moving average value from a point in time (n-i) to a point in time ((n-i)-k). This may be expressed as Equation 2 below.

【Equation 2】

$$H_{diff} = H_n - (( \sum_{m=0}^{k} H_{(n-i)-m})/(k+1))$$

(Hdiff: low-order harmonics moving average variation, Hn: RMS of second to fifth order harmonics at the current point in time (n), i: islanding detection reference time)

After that, the processor 111 determines that the low-order harmonics have occurred due to the grid interruption, when a result value of Equation 2 above exceeds the low-order harmonics detection reference value $\alpha$, by using Equation 3 below.

【Equation 3】

$$(H_{diff} - \alpha) > 0$$

($\alpha$: low-order harmonic detection reference value)

FIG. 5 is a flowchart illustrating an example of processes for injecting reactive power according to an embodiment.

FIG. 5 shows an example in which the processor 111 injects reactive power according to an improved frequency feedback technique. For example, operations shown in FIG. 5 may be performed before operation S10 of FIG. 3.

Hereinafter, the grid frequency variation after the reactive power injection is referred to as a first grid frequency variation, and the grid frequency variation before the reactive power injection is referred to as a second grid frequency variation.

In operation S510, the processor 111 identifies the second grid frequency variation before reactive power injection. For example, the processor 111 may identify the second grid frequency variation by the method described above with reference to FIG. 4.

In addition, the processor 111 may identify a direction in which the reactive power is injected, the reactive power being injected based on the second grid frequency variation. To this end, in operation S520, the processor 111 may identify a sign of the second grid frequency variation.

When the sign of the second grid frequency variation is a positive sign (Yes in operation S520), the processor 111 may determine the injection direction of a second reactive power to be capacitive in operation S530. Alternatively, when the sign of the second grid frequency variation is a negative sign (No in operation S520), the processor 111 may determine the injection direction of the second reactive power to be inductive in operation S540. As the processor 111 performs operations S530 and S540, the reactive power may be injected in a direction of maximizing the frequency fluctuation according to the sign of the frequency variation. Accordingly, the processor 111 may detect the islanding more accurately.

In operation S550, the processor 111 injects the second reactive power in the determined injection direction for a predefined period.

When the grid is actually shut off, only the PCS 110 and the load 120 are physically connected, and thus, the frequency is dominantly determined by the reactive power output from the PCS 110. That is, when the directivity of the reactive power is unstable, the entire AC system is unstable and may oscillate.

According to an embodiment, the processor 111 selects the direction of injected reactive power based on the sign of an initial grid frequency variation. Then, the processor 111 injects the reactive power in the selected direction for a certain period of time (e.g., 3-5 periods). This is because, when processes of deriving the sign and changing the injection direction of the reactive power are performed in each period, the frequency fluctuation is minor and the accuracy of detecting the islanding degrades.

When the direction of the reactive power is determined, the processor 111 injects the reactive power for a certain period of time in the same direction. Therefore, a phenomenon in which the grid frequency variation oscillates between the positive sign and the negative sign may be prevented.

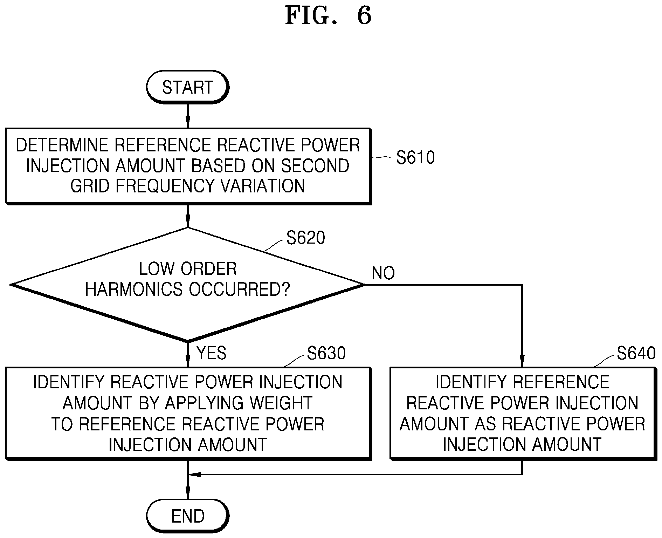

Here, the injection amount of the reactive power may be determined by the low-order harmonic variation and the second grid frequency variation. An example in which the processor 111 identifies the injection amount of reactive power is described with reference to FIG. 6.

FIG. 6 is a flowchart illustrating an example of processes of identifying a reactive power injection amount according to an embodiment.

FIG. 6 shows an example in which the processor 111 identifies the injection amount in the process of injecting the reactive power according to the improved frequency feedback technique. Therefore, hereinafter, the descriptions overlapping the above description provided with reference to FIG. 5 is are omitted.

In general, an absolute amount of the injected reactive power is proportional to the grid frequency variation. However, because the islanding detection reference time is very short in some countries, there is a limitation in reducing the detection time even when the reactive power is injected only based on the grid frequency variation.

The processor 111 according to an embodiment may add a weight to the injected reactive power according to the occurrence of low-order harmonics, additionally in consideration of the low-order harmonic variation in addition to the grid frequency variation.

For example, when the low-order harmonic variation is greater than or equal to a critical value, the processor 111 may add the weight to a reference reactive power injection amount that is determined in proportional to the grid frequency variation by using Equation 4 below. Accordingly, more reactive power may be injected. When the RMS of the low-order harmonics is less than a certain reference value, the processor 111 may initialize the weight.

【Equation 4】

$$Q_{IFF} = Q_{ramp} * (1 + \beta)$$

(QIFF: total reactive power injection amount by IFF function, Qramp: reference reactive power injection amount proportional to grid frequency variation, β: weight according to occurrence of low-order harmonic variation)

The above processes are described hereinafter. In operation S610, the processor 111 determines the reference reactive power injection amount based on the second grid frequency variation before the reactive power injection. Here, the reactive power injection amount that is determined only in consideration of the grid frequency variation is referred to as the reference reactive power injection amount. The processor 111 may identify the second grid frequency variation according to the method described above with reference to FIG. 4. For example, the reactive power injection amount may be defined in advance to be determined in proportional to the grid frequency variation.

However, when the processor 111 identifies the reactive power injection amount only in consideration of the grid frequency variation, there is a limitation in reducing the detection time.

Therefore, in operation S620, the processor 111 identifies whether low-order harmonics have occurred. When the low-order harmonics have occurred (Yes in operation S620), the processor 111 identifies the reactive power injection amount by applying a weight to the reference reactive power injection amount in operation S630. Here, when the low-order harmonic variation exceeds a critical value, the processor 111 identifies that the low-order harmonics have occurred. On the contrary, when the low-order harmonic variation does not exceed the critical value, the processor 111 identifies that the low-order harmonics do not occur.

When the low-order harmonics do not occur (No in operation S620), the processor 111 identifies the reference reactive power injection amount as the reactive power injection amount in operation S640.

As described above with reference to operation S550 of FIG. 5, the processor 111 maintains the directivity by maintaining the reactive power injection amount for a certain period.

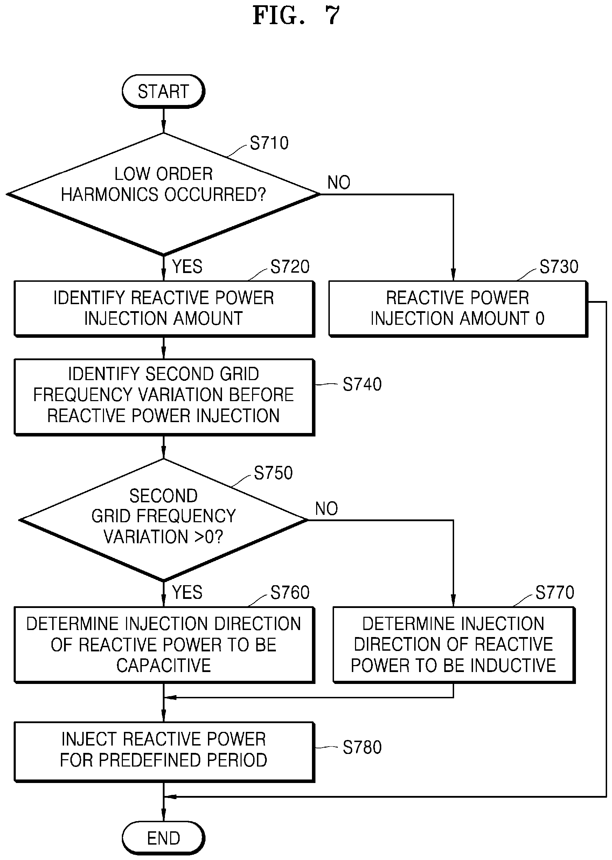

FIG. 7 is a flowchart illustrating another example of processes of injecting reactive power in a grid-connected system according to an embodiment.

FIG. 7 shows an example in which the processor 111 injects the reactive power according to a reactive power injection technique according to the occurrence of the low-order harmonics. For example, operations shown in FIG. 7 may be performed before performing operation S10 of FIG. 3.

Hereinafter, the grid frequency variation after the reactive power injection is referred to as the first grid frequency variation, and the grid frequency variation before the reactive power injection is referred to as the second grid frequency variation.

In operation S710, the processor 111 identifies whether the low-order harmonics have occurred. For example, the processor 111 may determine whether the low-order harmonics have occurred according to whether the low-order harmonic variation exceeds a critical value.

When the low-order harmonics have occurred (Yes in operation S710), the processor 111 identifies the reactive power injection amount based on the low-order harmonic variation in operation S720. For example, the reactive power injection amount may be defined in advance to be determined in proportional to the low-order harmonic variation.

When the low-order harmonics do not occur (No in operation S710), the processor 111 identify the reactive power injection amount as 0 and ends the algorithm in operation S730.

In operation S740, the processor 111 identifies the second grid frequency variation before the reactive power injection. In addition, in operation S750, the processor 111 determines the sign of the second grid frequency variation. When the sign of the second grid frequency variation is a positive sign (Yes in operation S750), the processor 111 determines the injection direction of the reactive power to be capacitive in operation S760. When the sign of the second grid frequency variation is a negative sign (No in operation S750), the processor 111 determines the injection direction of the reactive power to be inductive in operation S770.

In operation S780, the processor 111 injects the reactive power in the determined injection direction for a predefined period. For example, the processor 111 injects reactive power in the determined direction for a certain period of time (e.g., 3-5 periods). Therefore, a phenomenon in which the frequency variation oscillates between the positive sign and the negative sign may be prevented.

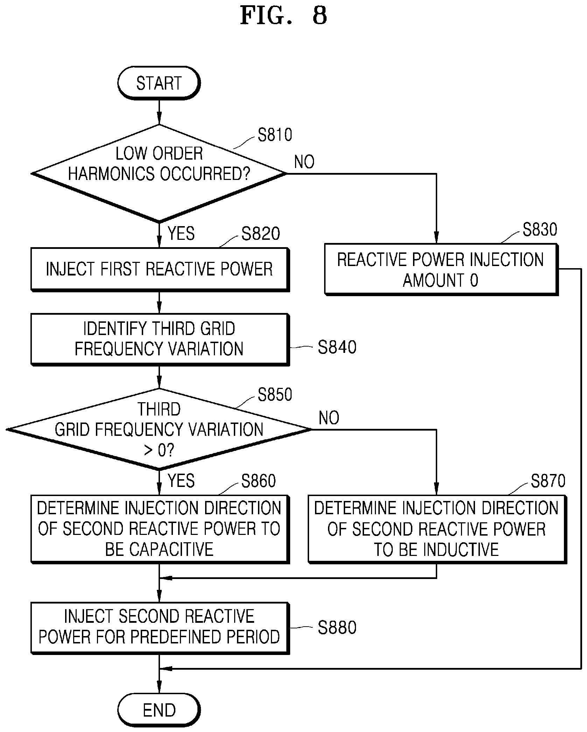

FIG. 8 is a flowchart illustrating another example of processes of injecting reactive power in a grid-connected system according to an embodiment.

FIG. 8 shows an example in which the processor 111 injects the reactive power in consideration of both the improved frequency feedback technique and the reactive power injection technique by the occurrence of the low-order harmonics. For example, operations shown in FIG. 8 may be performed before performing operation S10 of FIG. 3.

Hereinafter, the reactive power is injected twice. The reactive power injected according to the occurrence of the low-order harmonics is referred to as the first reactive power, and the reactive power injected according to the improved frequency feedback technique is referred to as the second reactive power. Also, the grid frequency variation after the first reactive power injection is referred to as a third grid frequency variation, and the grid frequency variation after the second reactive power injection is referred to as the first grid frequency variation.

When the grid frequency variation is minor, it may be difficult to detect whether the frequency temporarily changes due to external factors in a normal grid-connected operating situation or the frequency changes due to the islanding.

According to an embodiment, even when the occurrence of the frequency variation during the islanding is nearly 0, the reactive power injection technique due to the occurrence of the low-order harmonics is activated. Therefore, the reactive power output and the grid frequency fluctuation in the actual inverter product are induced. After that, a series of operations in which the grid frequency rapidly changes due to the reactive power injection and the second reactive power is injected by the improved frequency feedback technique may be possibly performed.

Therefore, the processor 111 one-time injects the reactive power according to the low-order harmonic variation, and then observes the measured frequency variation. Hereinafter, the above-described operations are described below.

In operation S8100, the processor 111 identifies whether low-order harmonics have occurred. For example, the processor 111 may determine whether the low-order harmonics have occurred according to whether the low-order harmonic variation exceeds a critical value.

When the low-order harmonics have occurred (Yes in operation S810), the processor 111 injects the first reactive power based on the low-order harmonic variation in operation S820. For example, the first reactive power injection amount may be defined in advance to be determined in proportional to the low-order harmonic variation.

When the low-order harmonics do not occur (No in operation S810), the processor 111 identify the reactive power injection amount as 0 and ends the main algorithm in operation S830.

In operation S840, the processor 111 identifies the third grid frequency variation after the first reactive power injection. In addition, the processor 111 determines the sign of the third grid frequency variation. When the sign of the third grid frequency variation is a positive sign (Yes in operation S850), the processor 111 may determine the injection direction of the second reactive power to be capacitive in operation S860. When the sign of the third grid frequency variation is a negative sign (No in operation S850), the injection direction of the second reactive power is determined to be inductive in operation S870.

The method of determining the injection amount of the second reactive power is as described above with reference to FIG. 6. In detail, the processor 111 determines a reference reactive power injection amount based on the third grid frequency variation, and applies a weight according to whether the low-order harmonics have occurred.

In operation S880, the processor 111 injects the second reactive power in the injection direction for a predefined period. Because the reactive power is injected in the determined direction for a certain period of time (e.g., 3-5 periods), the phenomenon in which the frequency variation oscillates between the positive sign and the negative sign may be prevented.

FIG. 9 is a flowchart illustrating an example of a technique for varying an islanding detection criterion according to the occurrence of low-order harmonic variation according to an embodiment.

Regarding operation S20 of FIG. 3, operation S710 of FIG. 7, and operation S810 of FIG. 8, the processor 111 may change the islanding detection determination criterion according to whether the low-order harmonics have occurred.

The criterion for detecting the islanding is a significant factor that is directly related to the sensitivity and reliability of the detecting function itself. When the detecting criterion is excessively generous and approximate, the detecting function may not operate in the actual situation of detecting the islanding. On the contrary, when the detecting criterion is excessively strict, the detecting criterion is too sensitive and there may be a possibility of malfunction, e.g., detection of the islanding in a situation such as fault rid through (FRT). Therefore, setting of the detecting criterion is evaluated as one of important factors determining the performance of the grid-connected system 1.

When the islanding occurs, the grid-side harmonics are increased by a combination of an AC output, a grid transformer, a load type, and an operation state of an inverter product that performs switching. Accordingly, the processor 111 flexibly changes the islanding detecting function with the RMS of the second to fifth order components of the low-order harmonics as a control element, the RMS of the second to fifth order components having the largest absolute physical quantity and largely affecting the electrical systems from among the harmonics.

In operation S910, the processor 111 identifies whether low-order harmonics have occurred. When the low-order harmonics have occurred (Yes in S910), the processor 111 increases the sensitivity of the criterion for detecting the islanding in operation S920. For example, the criterion for detecting the islanding may include a critical range of the grid frequency variation and the critical number of times, and a critical range of the measured frequency and the critical number of times.

When the low-order harmonics do not occur (No in S710), the processor 111 decreases (or maintains) the sensitivity of the criterion for detecting the islanding in operation S930.

The islanding detecting technique in operation S940 is described in detail below with reference to FIG. 10.

The present disclosure suggests a new method of improving the reliability in the function of detecting the islanding by flexibly changing the detecting conditions of the islanding under the condition in which the harmonics occur.

According to an embodiment, during the normal operation, the processor 111 generously sets the criterion for detecting the islanding. Therefore, a possibility of false detection of islanding due to unstable grid voltage fluctuation is decreased. In addition, in an actual islanding situation, the processor 111 detects the occurrence of harmonics and sets the detecting criterion to be sensitive. Therefore, the islanding may be detected even when the frequency fluctuation is minor.

FIG. 10 is a flowchart illustrating an example of an islanding detection technique according to an embodiment.

Hereinafter, regarding operation S30 of FIG. 3 and operation S940 of FIG. 9, an example in which the processor 111 detects the islanding is described below.

In operation S1010, the processor 111 identifies whether the grid frequency variation exceeds a critical range. Here, the grid frequency denotes the grid frequency after reactive power injection, and may be the first grid frequency variation.

When the grid frequency variation exceeds the critical range (Yes in operation S1010), the processor 111 accumulates the number of times of abnormalities in the grid frequency variation in operation S1020.

When the grid frequency variation is in the critical range (No in operation S1010), the processor 111 maintains the number of times of abnormalities in the grid frequency variation in operation S1030.

When the number of times that the grid frequency variation is abnormal exceeds the critical number of times (A) (Yes in operation S1040), the processor 111 identifies whether the measured frequency exceeds a critical range in operation S1050. When the measured frequency is less than or equal to the critical number of times (A) (No in operation S1040), the processor 111 may perform operation S1010 or ends the algorithm.

When the measured frequency exceeds the critical range (Yes in operation S1050), the processor 111 accumulates the number of times that the measured frequency is abnormal in operation S1060. When the measured frequency is in the critical range (No in operation S1050), the processor 111 maintains the number of times that the measured frequency is abnormal in operation S1070.

When the number of times that the measured frequency is abnormal exceeds the critical number of times (B) (Yes in operation S1080), the processor 111 determines the islanding in operation S1090. When the number of times that the measured frequency is abnormal is less than or equal to the critical number of times (B) (No in operation S1080), the processor 111 determines the normal operation in operation S1100.

According to an embodiment of the present disclosure, the processor 111 finally determines the islanding in consideration of both the frequency variation and the measured frequency value. Therefore, a false detection of the islanding under a phase shift situation may be prevented.

When the phase shift occurs once, the frequency variation and the measured frequency value are both changed. However, when the grid is stabilized later, the change in the frequency variation is sensed for a certain period of time, and the measured value in real-time is stabilized to a value within the normal range. The above case should not be determined as the islanding, and thus, it has to be cautious to avoid the false detection.

According to the present disclosure, the above situation may be dealt with, and reliability of the entire algorithm may be improved. Also, in the aspect of the protecting function that directly relates to the grid safety standards of the grid-connected system 1, the present disclosure may secure high reliability and may prevent accidents in actual industrial sites.

On the other hand, embodiments of the disclosure described above may be implemented in a general purpose digital computer to be written as a program that may be executed on a computer, and operate the programs using a computer readable recording medium. In addition, the structure of the data used in the above-described method may be recorded on a computer-readable recording medium through various means. Examples of the computer readable recording medium include magnetic storage media (e.g., ROM, RAM, USB drives, floppy disks, hard disks, etc.), optical recording media (e.g., CD-ROMs, or DVDs), etc.

It will be understood by one of ordinary skill in the art that various changes in form and details may be made therein without departing from the spirit and scope of the present disclosure as defined by the appended claims. Therefore, the disclosed methods should be considered from an explanatory rather than a limiting perspective, and the scope of rights is indicated in the claims, not the foregoing description, and should be interpreted to include all differences within the equivalent scope.

**Claims**

**1.** A power conditioning system comprising:

a processor that is configured to
identify a first grid frequency variation and a measured frequency according to injection of reactive power,
identify whether at least one of the first grid frequency variation or the measured frequency exceeds a critical range, and
detect an islanding based on the number of times of exceeding the critical range within a predefined period of time.

2. The power conditioning system of claim 1, wherein

the processor is further configured to
based on a zero-crossing point in time of a grid voltage, identify a low-order harmonic variation based on a difference between first low-order harmonics at a current point in time and second low-order harmonics at a previous point in time that is earlier than the current point in time as much as an islanding detection time, and the critical range is adjustable according to the low-order harmonic variation.

3. The power conditioning system of claim 2, wherein

the processor is further configured to
identify an injection direction of the reactive power based on a second grid frequency variation before the reactive power injection, and
inject the reactive power in the injection direction by an injection amount that is identified based on the low-order harmonic variation and the second grid frequency variation.

4. The power conditioning system of claim 3, wherein

the processor is further configured to
identify the injection direction of the reactive power to be capacitive when the second grid frequency variation has a positive sign and to be inductive when the second grid frequency variation has a negative sign.

5. The power conditioning system of claim 4, wherein

the processor is further configured to
identify the injection amount of the reactive power by applying a weight according to the low-order harmonic variation to a reference reactive power injection amount that is determined based on the second grid frequency variation.

6. The power conditioning system of claim 4, wherein

the processor is further configured to
inject the injection amount of the reactive power in the injection direction for a predefined period.

7. The power conditioning system of claim 2, wherein

the processor is further configured to
inject the reactive power based on that the low-order harmonic variation exceeds a critical value.

8. The power conditioning system of claim 7, wherein

the processor is further configured to
inject the reactive power in an injection direction of the reactive power, the injection direction being identified based on the second grid frequency variation before the reactive power injection.

9. The power conditioning system of claim 8, wherein

the processor is further configured to
identify the injection direction of the reactive power to be capacitive when the second grid frequency variation has a positive sign and to be inductive when the second grid frequency variation has a negative sign.

10. The power conditioning system of claim 9, wherein

the processor is further configured to
inject injection amount of the reactive power in the injection direction for a predefined period.

11. The power conditioning system of claim 2, wherein

the reactive power includes first reactive power and second reactive power, and
the processor is further configured to
inject the first reactive power identified based on that the low-order harmonic variation exceeds critical value, and
inject the second reactive power identified based on third grid frequency variation according to the injection of the first reactive power.

12. A method of detecting an islanding, the method comprising:

identifying a first grid frequency variation and a measured frequency according to injection of reactive power;
identifying whether at least one of the first grid frequency variation or the measured frequency exceeds a critical range; and
detecting an islanding based on the number of times of exceeding the critical range within a predefined period of time.

13. The method of claim 12, further comprising;
based on a zero-crossing point in time of a grid voltage, identifying a low-order harmonic variation through a difference between first low-order harmonics at a current point in time and second low-order harmonics at a previous point in time that is earlier than the current point in time as much as an islanding detection time.

14. The method of claim 13, further comprising:

identifying an injection direction of the reactive power to be capacitive when second grid frequency variation before the reactive power injection has a positive sign and to be inductive when the second grid frequency variation before the reactive power injection has a negative sign; and
injecting the reactive power in the injecting direction by an injection amount identified by applying a weight according to the low-order harmonic variation to a reference reactive power injection amount that is determined based on the second grid frequency variation.

15. The method of claim 14, wherein

the injecting of the reactive power comprises injecting the injection amount of the reactive power in the injection direction for a predefined period.

16. The method of claim 13, further comprising injecting the reactive power based on that the low-order harmonic variation exceeds a critical value.

17. The method of claim 16, wherein

the injecting of the reactive power comprises identifying injection direction of the reactive power to be capacitive when second grid frequency variation before reactive power injection has a positive sign and to be inductive when the second grid frequency variation before the reactive power injection has a negative sign; and
injecting the reactive power in the injection direction by an injection amount identified based on the low-order harmonics.

18. The method of claim 17, wherein

the injecting of the reactive power comprises injecting the injection amount of the reactive power in the injection direction for a predefined period.

19. The method of claim 13, wherein

the reactive power includes first reactive power and second reactive power, and

the method further comprises:

injecting the first reactive power identified based on that the low-order harmonic variation exceeds a critical value; and
injecting the second reactive power identified based on a third grid frequency variation according to the injection of the first reactive power.

20. A computer-readable recording medium having recorded thereon
a program for causing a computer to execute the method of claim 12.

# FIG. 1

# FIG. 2

START

210
IMPROVED FREQUENCY
FEEDBACK FUNCTION

220
REACTIVE POWER
INJECTION METHOD BY
LOW ORDER HARMONICS

230
ISLANDING DETECTING
CONDITION VARIATION
TECHNIQUE BY LOW
ORDER HARMONICS

240
ISLANDING DETECTION
TECHNIQUE

END

# FIG. 3

```
            ( START )
                │
                ▼
┌─────────────────────────────────────┐
│ IDENTIFY FIRST GRID FREQUENCY VARIATION │ ── S10
│ AND MEASURED FREQEUNCY ACCORDING TO     │
│ INJECTION OF REACTIVE POWER             │
└─────────────────────────────────────┘
                │
                ▼
┌─────────────────────────────────────┐
│ IDENTIFY WHETHER AT LEAST ONE OF FIRST  │ ── S20
│ GRID FREQUENCY VARIATION OR MEASURED    │
│ FREQUENCY EXCEEDS CRITICAL RANGE        │
└─────────────────────────────────────┘
                │
                ▼
┌─────────────────────────────────────┐
│ DETECT ISLANDING BASED ON NUMBER        │ ── S30
│ OF TIMES OF EXCEEDING CRITICAL RANGE    │
│ FOR PREDEFINED PERIOD OF TIME           │
└─────────────────────────────────────┘
                │
                ▼
             ( END )
```

# FIG. 4

PAST MOVING AVERAGE | ISLANDING DETECTION REFERENCE TIME (=i) | CURRENT POINT IN TIME(n)

(n-i)-k | · · · | (n-i)-1 | n-i | · · · | n-3 | n-2 | n-1 | n

EP 4 506 705 A1

# FIG. 5

START

IDENTIFY SECOND GRID
FREQUENCY VARIATION BEFORE — S510
REACTIVE POWER INJECTION

S520

SECOND GRID
FREQUENCY VARIATION        NO
>0 ?

YES — S530                                                    S540

DETERMINE INJECTION          DETERMINE INJECTION
DIRECTION OF REACTIVE         DIRECTION OF REACTIVE
POWER TO BE CAPACITIVE        POWER TO BE INDUCTIVE

INJECT REACTIVE POWER
FOR PREDEFINED PERIOD — S550

END

# FIG. 6

START

DETERMINE REFERENCE REACTIVE POWER INJECTION AMOUNT BASED ON SECOND GRID FREQUENCY VARIATION — S610

LOW ORDER HARMONICS OCCURRED? — S620

NO

YES

IDENTIFY REACTIVE POWER INJECTION AMOUNT BY APPLYING WEIGHT TO REFERENCE REACTIVE POWER INJECTION AMOUNT — S630

IDENTIFY REFERENCE REACTIVE POWER INJECTION AMOUNT AS REACTIVE POWER INJECTION AMOUNT — S640

END

# FIG. 7

```
                    ┌─────────┐
                    │  START  │
                    └────┬────┘
                         │
                         │          ╱─S710
              ╱─────────────────────╲
            ╱      LOW ORDER          ╲        NO
            ╲   HARMONICS OCCURRED?   ╱─────────────────────┐
              ╲─────────────────────╱                        │
                    │ YES    ╱─S720                           │ ╱─S730
            ┌───────┴────────────┐         ┌─────────────────┴───┐
            │ IDENTIFY REACTIVE  │         │  REACTIVE POWER      │
            │   POWER INJECTION  │         │  INJECTION AMOUNT 0  │
            │      AMOUNT        │         └─────────────────────┘
            └───────┬────────────┘                            │
                    │                                          │
            ┌───────┴────────────┐   ╱─S740                   │
            │ IDENTIFY SECOND    │                            │
            │ GRID FREQUENCY     │                            │
            │ VARIATION BEFORE   │                            │
            │ REACTIVE POWER     │                            │
            │ INJECTION          │                            │
            └───────┬────────────┘                            │
                    │          ╱─S750                          │
              ╱─────────────────────╲                         │
            ╱       SECOND           ╲      NO                 │
            ╲   GRID FREQUENCY        ╱──────────┐             │
            ╲   VARIATION >0?        ╱            │            │
              ╲─────────────────────╱             │            │
                    │ YES   ╱─S760                 │ ╱─S770     │
            ┌───────┴────────────┐      ┌──────────┴──────┐    │
            │ DETERMINE INJECTION│      │ DETERMINE       │    │
            │ DIRECTION OF       │      │ INJECTION       │    │
            │ REACTIVE POWER TO  │      │ DIRECTION OF    │    │
            │ BE CAPACITIVE      │      │ REACTIVE POWER  │    │
            └───────┬────────────┘      │ TO BE INDUCTIVE │    │
                    │◄───────────────────└─────────────────┘   │
            ┌───────┴────────────┐   ╱─S780                    │
            │ INJECT REACTIVE    │                             │
            │ POWER FOR          │                             │
            │ PREDEFINED PERIOD  │                             │
            └───────┬────────────┘                             │
                    │◄─────────────────────────────────────────┘
                ┌───┴───┐
                │  END  │
                └───────┘
```

# FIG. 8

```
                    ┌─────────┐
                    │  START  │
                    └────┬────┘
                         │
                         ▼
                    ╱─────────────╲         S810
                  ╱  LOW ORDER      ╲──────────
                 ╱ HARMONICS OCCURRED?╲    NO ──────────┐
                  ╲                  ╱                   │
                    ╲─────────────╱                      │
                         │ YES    S820                   ▼
                         ▼                                        S830
              ┌──────────────────────┐      ┌──────────────────────────┐
              │ INJECT FIRST REACTIVE │      │ REACTIVE POWER INJECTION │
              │        POWER          │      │        AMOUNT 0          │
              └──────────┬───────────┘      └────────────┬─────────────┘
                         │                               │
                         ▼                               │
              ┌──────────────────────┐                   │
              │  IDENTIFY THIRD GRID  │── S840            │
              │ FREQUENCY VARIATION   │                   │
              └──────────┬───────────┘                   │
                         │                               │
                         ▼                               │
                    ╱─────────────╲     S850              │
                  ╱     THIRD       ╲──────                │
                 ╱ GRID FREQUENCY VARIATION╲  NO ──────┐   │
                 ╲       > 0?      ╱                   │   │
                    ╲─────────────╱                    │   │
                         │ YES   S860                  │   │
                         ▼                       S870  ▼   │
         ┌──────────────────────────┐   ┌──────────────────────────┐
         │ DETERMINE INJECTION DIRECTION│   │ DETERMINE INJECTION DIRECTION│
         │ OF SECOND REACTIVE POWER TO  │   │ OF SECOND REACTIVE POWER     │
         │       BE CAPACITIVE          │   │       TO BE INDUCTIVE        │
         └──────────────┬───────────────┘   └──────────────┬───────────────┘
                        │                                  │
                        ▼──────────────────────────────────┘
         ┌──────────────────────────┐
         │  INJECT SECOND REACTIVE   │── S880
         │ POWER FOR PREDEFINED PERIOD│
         └──────────────┬───────────┘
                        │◄────────────────────────────────────┘
                        ▼
                    ┌─────────┐
                    │   END   │
                    └─────────┘
```

# FIG. 9

START
↓
LOW ORDER HARMONICS OCCURRED? — S910
↓ YES / NO →

INCREASE SENSITIVITY IN ISLANDING DETECTION REFERENCE — S920

DECREASE SENSITIVITY IN ISLANDING DETECTION REFERENCE — S930

ISLANDING DETECTION TECHNIQUE — S940
↓
END

# FIG. 10

```
                    START
                      │
                      ▼
              ┌───────────────┐      S1010
          ╱───┤  DOES GRID    ├───╲      NO
         ╱    FREQUENCY VARIATION EXCEED ╲─────────────────────┐
         ╲    CRITICAL RANGE?           ╱                      │
          ╲───┬───────────────────────╱                       │
              │ YES      S1020                    S1030        │
              ▼                                                │
    ┌──────────────────────┐           ┌──────────────────────┐
    │ ACCUMULATE NUMBER OF │           │ MAINTAIN NUMBER OF   │
    │ TIMES OF ABNORMALITY │           │ TIMES OF ABNORMALITY │
    │ IN GRID FREQUENCY    │           │ IN GRID FREQUENCY    │
    │ VARIATION            │           │ VARIATION            │
    └──────────┬───────────┘           └──────────┬───────────┘
               │◄─────────────────────────────────┘
               ▼
        ┌─────────────┐          S1040
    ╱───┤   NUMBER    ├───╲          NO
   ╱    OF TIMES OF ABNORMALITY >  ╲──────────────────────────┐
   ╲    CRITICAL NUMBER OF         ╱                           │
    ╲   TIMES (A)                 ╱                            │
     ╲──────┬────────────────────╱                             │
            │ YES                                              │
            ▼                                                  │
        ┌─────────────┐          S1050                         │
    ╱───┤  DOES MEASURED ├───╲       NO                        │
   ╱    FREQUENCY EXCEED PREDEFINED ╲─────────────┐            │
   ╲    RANGE?                      ╱              │            │
    ╲──────┬───────────────────────╱              │            │
           │ YES      S1060                 S1070  │            │
           ▼                                       ▼            │
  ┌──────────────────────┐          ┌──────────────────────┐  │
  │ ACCUMULATE NUMBER OF │          │ MAINTAIN NUMBER OF   │  │
  │ TIMES OF ABNORMALITY │          │ TIMES OF ABNORMALITY │  │
  │ IN MEASURED FREQUENCY│          │ IN MEASURED FREQUENCY│  │
  └──────────┬───────────┘          └──────────┬───────────┘  │
             │                                  │              │
             └──────────────┬───────────────────┘              │
                            ▼                                  │
                    ┌─────────────┐       S1080                │
                ╱───┤  NUMBER OF  ├───╲        NO              │
               ╱    TIMES OF ABNORMALITY > CRITICAL ╲──────────┤
               ╲    NUMBER OF TIMES (B)            ╱            │
                ╲──────┬──────────────────────────╱            │
                       │ YES    S1090          S1100           │
                       ▼                         ▼             │
              ┌─────────────────┐     ┌──────────────────────┐ │
              │ DETECT ISLANDING│     │ DETECT NORMAL OPERATION│ │
              └────────┬────────┘     └──────────┬───────────┘ │
                       │◄────────────────────────┘
                       ▼
                     END
```

## INTERNATIONAL SEARCH REPORT

| International application No. |
| --- |
| **PCT/KR2024/003687** |

### A. CLASSIFICATION OF SUBJECT MATTER

**G01R 31/40**(2006.01)i; **G01R 19/175**(2006.01)i; **G01R 23/00**(2006.01)i; **G01R 23/20**(2006.01)i; **G01R 21/00**(2006.01)i

According to International Patent Classification (IPC) or to both national classification and IPC

### B. FIELDS SEARCHED

Minimum documentation searched (classification system followed by classification symbols)

G01R 31/40(2006.01); G01R 11/16(2006.01); G01R 19/25(2006.01); G01R 23/20(2006.01); G01R 27/16(2006.01); G01R 31/00(2006.01); G05B 19/418(2006.01); G05B 23/00(2006.01); H02H 3/52(2006.01); H02J 3/38(2006.01); H02M 7/48(2007.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 무효 전력(reactive power), 주파수(frequency), 편차(deviation), 식별(identification), 임계 범위(critical range), 프로세서(processor), 전력 변환 장치(power conditioning system)

### C. DOCUMENTS CONSIDERED TO BE RELEVANT

| Category* | Citation of document, with indication, where appropriate, of the relevant passages | Relevant to claim No. |
| --- | --- | --- |
| X | JP 2014-212631 A (SHARP CORP.) 13 November 2014 (2014-11-13)<br>See paragraphs [0011]-[0129]; claim 1; and figures 1-24. | 1-20 |
| A | KR 10-2021-0057363 A (KOREA ELECTROTECHNOLOGY RESEARCH INSTITUTE) 21 May 2021 (2021-05-21)<br>See claims 1-4; and figure 2. | 1-20 |
| A | KR 10-2017-0009531 A (SAMSUNG SDI CO., LTD.) 25 January 2017 (2017-01-25)<br>See paragraphs [0028]-[0051]; and figures 2-3. | 1-20 |
| A | KR 10-2011-0105981 A (CHUNGJU NATIONAL UNIVERSITY INDUSTRY-ACADEMIC COOPERATION FOUNDATION) 28 September 2011 (2011-09-28)<br>See paragraphs [0017]-[0070]; and figures 1-2. | 1-20 |

☑ Further documents are listed in the continuation of Box C.     ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **26 June 2024** | **27 June 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2024/003687** |

**C.      DOCUMENTS CONSIDERED TO BE RELEVANT**

| Category* | Citation of document, with indication, where appropriate, of the relevant passages | Relevant to claim No. |
| --- | --- | --- |
| A | KR 10-2149438 B1 (DREAM ENGINEERING) 31 August 2020 (2020-08-31)<br>See paragraphs [0031]-[0033]; and figure 2. | 1-20 |

Form PCT/ISA/210 (second sheet) (July 2022)

## INTERNATIONAL SEARCH REPORT
### Information on patent family members

International application No.

**PCT/KR2024/003687**

| Patent document cited in search report | | | Publication date (day/month/year) | Patent family member(s) | | | Publication date (day/month/year) |
|---|---|---|---|---|---|---|---|
| JP | 2014-212631 | A | 13 November 2014 | JP | 6200196 | B2 | 20 September 2017 |
| KR | 10-2021-0057363 | A | 21 May 2021 | None | | | |
| KR | 10-2017-0009531 | A | 25 January 2017 | None | | | |
| KR | 10-2011-0105981 | A | 28 September 2011 | KR | 10-1072016 | B1 | 10 October 2011 |
| KR | 10-2149438 | B1 | 31 August 2020 | None | | | |

Form PCT/ISA/210 (patent family annex) (July 2022)